# FASCICULE DE BREVET EUROPEEN

(11) **EP 0 660 140 B1**
(45) Date de publication et mention de la délivrance du brevet: **08.03.2000**
(21) Numéro de dépôt: 94402969.3
(22) Date de dépôt: 21.12.1994
(51) Int. Cl.: G02B 5/18, G02B 6/12

(54) **Procédé de réalisation d'une structure en relief sur un support en matériau semi-conducteur**
Herstellungsverfahren für eine Reliefstruktur auf einem Substrat aus Halbleitermaterial
Method for making a relief structure on a substrate from semiconductor material

(30) Priorité: 23.12.1993 FR 9315563
(43) Date de publication de la demande: 28.06.1995
(73) Titulaire: COMMISSARIAT A L'ENERGIE ATOMIQUE, 75015 Paris (FR)
(72) Inventeur: Bruel, Michel, F-38113 Veurey (FR)
(74) Mandataire: Dubois-Chabert, Guy

(56) Documents cités:
- EP-A- 0 533 551
- GB-A- 2 211 991
- US-A- 4 717 683

## Description

La présente invention concerne un procédé de réalisation d'une structure en relief sur un support en matériau semiconducteur. Ce procédé permet en particulier de réaliser avantageusement des dispositifs pour l'optique binaire sur un support en matériau semiconducteur, notamment en silicium.

Les principes de base de l'optique binaire sont simples et s'appliquent aussi bien à une optique en réflexion qu'à une optique en réfraction. Ces principes ont été rappelés dans l'article "Binary Optics" de W.B. VELDKAMP et T.J. McHUGH, paru dans la revue Scientific American de Mai 1992.

Une des structures les plus simples que l'on puisse réaliser en optique binaire est le prisme qui se présente comme une série de micro-marches d'escalier taillées dans la surface du matériau. Quand un front d'onde arrive à la surface, cette onde est séparée en fronts d'ondes secondaires (selon le principe de Huygens-Fresnel). Chaque front d'onde secondaire est retardé en proportion de la hauteur de la marche en ce point c'est-à-dire du supplément de chemin optique traversé. Quand ces fronts d'onde interfèrent entre eux, ils produisent un nouveau front d'onde se propageant avec un certain angle par rapport à la direction du front d'onde incident.

Dans l'approche optique binaire, il suffit d'une épaisseur de matériau de l'ordre du µm (correspondant à la longueur d'onde λ d'un faisceau lumineux incident) pour obtenir l'effet de déflexion alors qu'en approche conventionnelle, il aurait fallu une pièce en verre de plusieurs millimètres d'épaisseur.

La réalisation de dispositifs d'optique binaire requiert donc de savoir réaliser localement à la surface d'un matériau des zones en sur-épaisseur ou sous-épaisseur (la sur-épaisseur ou la sous-épaisseur devant être obtenue précisément car correspondant à une fraction de la longueur d'onde d'utilisation du dispositif). La localisation de ces zones est dépendante de la fonction optique à réaliser. Dans une même optique, on peut trouver plusieurs gammes de sur-épaisseurs (ou sous-épaisseurs) par exemple correspondant à des différences de marche de λ/8, λ/4, 3λ/8, λ/2, etc.

Classiquement, pour réaliser un tel dispositif d'optique binaire, on utilise les techniques de dépôt en couche mince, lorsque l'on veut faire une réalisation en relief, associée à des techniques de lithographie et de gravure pour la localisation des zones en sur-épaisseur. Lorsque l'on veut faire une réalisation en creux, on utilise les techniques de lithographie pour la localisation et de gravure (sèche par exemple).

Ces procédés de fabrication selon l'art connu présentent des inconvénients relatifs au contrôle et à la reproductibilité des épaisseurs des zones, et relatifs également à la complexité des opérations nécessaires pour réaliser plusieurs gammes d'épaisseurs.

En ce qui concerne le contrôle et la reproductibilité des épaisseurs, le résultat obtenu est lié à une cinétique de réaction et au temps d'application de la réaction. Généralement, on règle les paramètres du procédé et on l'applique pendant une durée prévue. On n'a en général pas d'indicateur, pendant l'application du procédé, de l'épaisseur (ou profondeur) courante réalisée. L'incertitude sur le résultat peut être grande.

Pour réaliser plusieurs gammes d'épaisseurs, on constate que, quand le procédé est appliqué pour réaliser une gamme d'épaisseur dans une zone donnée, les autres zones doivent être protégées de l'application du procédé. Ceci induit une complexité au niveau de la lithographie ainsi que des problèmes de frontière entre zones dues à des alignements imparfaits.

On connaît d'autre part, par le document FR-A-2 681 472, un procédé de fabrication de films minces de matériau semiconducteur comprenant trois étapes. Dans une première étape, on crée par implantation ionique une couche de microbulles gazeuses sous une face d'une plaquette de matériau semiconducteur. Dans une seconde étape, la face de la plaquette est rendue solidaire d'un raidisseur. Dans une troisième étape, l'ensemble constitué par la plaquette et le raidisseur est soumis à une température suffisante pour créer, par effet de réarrangement cristallin dans la plaquette et de pression dans les microbulles, un clivage de la plaquette au niveau de la couche de microbulles. On obtient ainsi un film mince adhérant au raidisseur.

La présente invention propose un nouveau procédé de réalisation d'une structure en relief sur un support en matériau semiconducteur qui met en oeuvre une technique dérivée de l'enseignement du document FR-A-2 681 472. Ce nouveau procédé permet ainsi de remédier aux inconvénients des procédés de fabrication selon l'art connu.

L'invention a donc pour objet un procédé de réalisation d'une structure en relief sur un support en matériau semiconducteur, caractérisé en ce qu'il consiste à soumettre une plaquette de ce matériau semiconducteur comportant une face plane dont le plan est soit sensiblement parallèle à un plan cristallographique principal dans le cas où le matériau semiconducteur est monocristallin, soit faiblement incliné par rapport à un plan cristallographique de mêmes indices pour tous les grains dans le cas où le matériau est polycristallin, aux trois étapes suivantes :
- une première étape d'implantation par bombardement de la face plane de ladite plaquette au moyen d'ions, créant des zones de microbulles gazeuses, l'ensemble des zones définissant un profil dans le volume de ladite plaquette, chaque zone étant située par rapport à ladite face plane à une profondeur dépendant de l'énergie d'implantation des ions reçue par la surface de la face en regard de cette zone et étant de même géométrie que cette surface, ce profil délimitant, du côté de la face plane, une région supérieure de la plaquette constituant un film mince et, du côté opposé à la face plane, une région inférieure constituant la masse du substrat, les ions étant choisis parmi les ions de gaz rares ou de gaz hydrogène et la température de la plaquette pendant l'implantation étant maintenue au-dessous de la température à laquelle le gaz engendré par les ions implantés peut s'échapper du semiconducteur par diffusion ;
- une deuxième étape de solidarisation de la face plane de ladite plaquette avec un raidisseur constitué d'au moins une couche de matériau rigide ;
- une troisième étape de traitement thermique de l'ensemble constitué par la plaquette et le raidisseur à une température suffisante pour créer une séparation entre le film mince et la masse du substrat le long dudit profil, la séparation procurant une structure en relief sur le film mince et une structure en relief inversé sur le substrat.

Lors de la première étape, les zones de microbulles gazeuses d'énergies d'implantation différentes peuvent être obtenues par des étapes d'implantation successives.

Lors de la première étape, toutes les zones de microbulles gazeuses peuvent être créées simultanément grâce à un écran disposé sur le trajet des ions, cet écran étant apte à être traversé par les ions tout en atténuant leurs énergies et ayant une épaisseur variant localement selon un motif correspondant aux zones de microbulles à créer pour laisser passer l'énergie d'implantation nécessaire pour chaque zone.

En vue d'obtenir un profil de structure déterminé, on peut réaliser d'abord une structure en relief approchant par excès ledit profil déterminé, puis procéder à une quatrième étape consistant à polir la structure approchante jusqu'à atteindre le profil déterminé.

En vue d'obtenir un profil de structure déterminé, on peut réaliser d'abord une structure en relief approchant par défaut ledit profil déterminé, puis procéder à une quatrième étape consistant à combler la structure approchante jusqu'à atteindre le profil déterminé.

Le semiconducteur peut être du silicium, les ions implantés des ions de gaz hydrogène ou d'hélium, la température d'implantation comprise entre 20°C et 400°C et la température de la troisième étape de traitement thermique supérieure à 450°C.

L'invention sera mieux comprise et d'autres avantages et particularités apparaîtront à la lecture de la description qui va suivre, donnée à titre d'exemple non limitatif, accompagnée des dessins annexés parmi lesquels :
- les figures 1 à 4 illustrent un premier mode d'application du procédé de réalisation d'une structure en relief selon l'invention,
- les figures 5 à 7 illustrent un deuxième mode d'application du procédé de réalisation d'une structure en relief selon l'invention,
- la figure 8 représente une vue partielle en perspective d'un dispositif d'optique binaire réalisé par le procédé selon l'invention,
- les figures 9 et 10 illustrent une autre réalisation obtenue par le procédé selon l'invention.

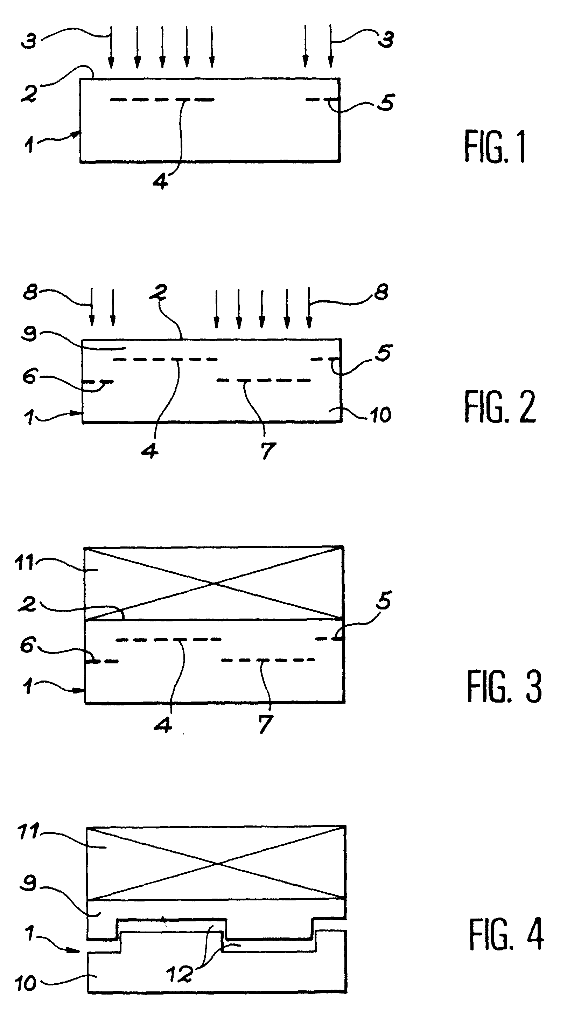

A la figure 1, on a représenté une plaquette 1 en matériau semiconducteur par exemple en silicium monocristallin. Cette plaquette est vue de côté. Elle comporte une face plane supérieure 2 à travers laquelle on va réaliser par implantation des zones de microbulles gazeuses dans son volume. On suppose qu'on veuille y implanter deux zones correspondant à un premier niveau d'énergie des ions et deux zones correspondant à un deuxième niveau d'énergie des ions, ce deuxième niveau d'énergie étant plus élevé que le premier.

Les ions utilisés pour l'implantation par bombardement sont par exemple des ions H⁺, mais on peut également utiliser des ions moléculaires d'hydrogène ou des ions de gaz rares tels que l'hélium, le néon, le krypton et le xénon, utilisés isolément ou en combinaison. L'objet de la présente invention s'applique particulièrement bien aux semiconducteurs du groupe IV, par exemple le silicium, le germanium, le carbure de silicium, les alliages silicium-germanium.

On trouvera dans le document FR-A-2 681 472, déjà cité, des explications concernant l'implantation d'ions H⁺ dans une plaquette de silicium monocristallin.

Sur la figure 1, l'implantation d'ions référencés de manière générale 3 provoque, pour une énergie d'implantation donnée, deux zones de microbulles gazeuses 4 et 5 situées à une même profondeur de la face plane 2 de la plaquette 1. On peut implanter chaque zone 4 ou 5 successivement ou simultanément en disposant un masque sur le parcours du faisceau d'ions.

De la même façon, comme cela est illustré à la figure 2, on implante les zones 6 et 7 situées plus profondément dans la plaquette 1, par des ions d'énergie supérieure référencés de manière générale 8. Dans le cas présent, les zones 6 et 7 rejoignent les zones 4 et 5 si on projette toutes ces zones sur la face plane 2.

La localisation de l'implantation à des zones bien déterminées peut être réalisée grâce à des techniques connues, par exemple en utilisant une implantation au travers d'un masque de résine obtenu par photolitographie ou l'implantation au travers d'un masque métallique présentant des ouvertures.

L'ensemble des zones implantées constitue un profil délimitant une région supérieure 9 et une région inférieure 10 dans le volume de la plaquette.

La figure 3 montre la plaquette semiconductrice 1, obtenue à l'issue de la première étape, rendue solidaire d'un raidisseur 11 par sa face plane 2. Le raidisseur peut être fixé à la plaquette semiconductrice par collage grâce à une substance adhérant à la fois au raidisseur et à la plaquette. Mais de façon préférentielle, le raidisseur est solidaire de la plaquette par l'intermédiaire de liaisons inter-atomiques comme décrit dans les documents FR-A-2 681 472 ou EP-A-0 533 551. Le raidisseur doit en tout cas pouvoir supporter le traitement thermique de la troisième étape sans risquer de se dégrader, tout en restant solidaire de la plaquette.

Le traitement thermique doit être réalisé à une température telle que le réarrangement cristallin et la coalescence des bulles puissent effectivement avoir lieu. Dans le cas d'une plaquette en silicium, une température supérieure à environ 450°C est nécessaire pour que la séparation puisse avoir lieu.

La figure 4 montre le résultat obtenu après le traitement thermique. Les régions supérieure 9 et inférieure 10 sont maintenant séparées par l'espace 12, à l'endroit des zones implantées et des zones de liaison entre ces zones. La fracture aux zones de liaison est due à la fragilisation induite entre deux plans de clivage relativement proches.

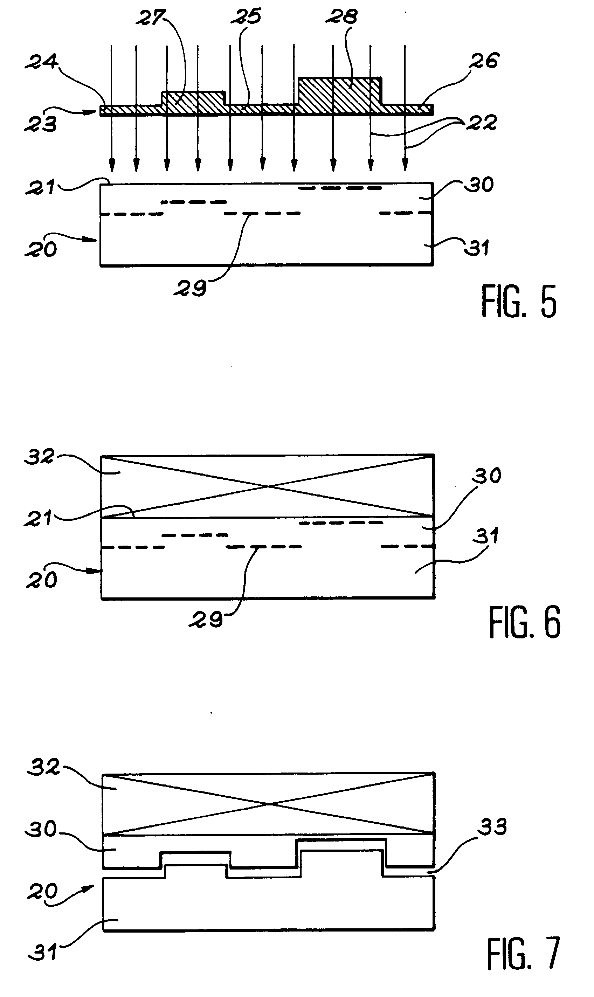

Les figures 5 à 7 illustrent un deuxième mode de réalisation de l'invention qui utilise un écran.

La plaquette 20 en matériau semiconducteur, par exemple en silicium monocristallin, comporte une face plane supérieure 21 à travers laquelle on va réaliser l'implantation qui va créer des zones de microbulles gazeuses dans son volume. L'implantation se fait en plaçant sur le trajet des ions, portant la référence générale 22, un écran 23 apte à être traversé par les ions mais dont l'épaisseur affecte l'énergie des ions. Plus l'écran est épais, plus l'énergie des ions sera réduite. Cet écran peut être réalisé en silicium par exemple ou en SiC.

L'écran 23 comporte, dans l'exemple représenté à la figure 5, trois épaisseurs différentes : les régions 24, 25 et 26 sont de même épaisseur, la région 27 est un peu plus épaisse et la région 28 encore un peu plus épaisse. Sur cet écran est réalisé en relief la structure que l'on veut obtenir dans la plaquette.

Le bombardement ionique, par exemple par des ions H⁺ d'énergie choisie, se fait sur toute la surface de la face plane 21, au travers de l'écran 23. Les ions pénètrent plus ou moins profondément dans la plaquette 20, en fonction de l'épaisseur de l'écran traversée. Ils provoquent un profil continu 29 de microbulles gazeuses délimitant une région supérieure 30 et une région inférieure 31 dans le volume de la plaquette.

Cette variante de réalisation est particulièrement intéressante car, une fois l'écran réalisé, il n'y a plus de problème de positionnement des différentes zones entre elles. Une seule implantation suffit et l'écran peut être utilisé plusieurs fois.

La suite des étapes est identique au premier mode d'application du procédé. La figure 6 représente la deuxième étape du procédé : un raidisseur 32 est solidarisé sur la face plane 21 de la plaquette 20. La figure 7 montre le résultat obtenu après le traitement thermique. Les régions supérieure 30 et inférieure 31 sont maintenant séparées par l'espace 33 à l'endroit des zones implantées et des zones de liaison, fracturées comme dans le premier mode décrit précédemment.

On obtient finalement une structure en relief sur le film mince adhérant au raidisseur et une structure de relief inversé sur le reste de la plaquette, c'est-à-dire sur un substrat semiconducteur.

Les structures ainsi obtenues peuvent comporter des variations de niveaux de l'ordre de quelques fractions de µm à quelques dizaines de µm. Les structures ainsi obtenues peuvent trouver une application dans le domaine de l'optique binaire et également servir de moule pour la réalisation d'un dispositif d'optique en polymère.

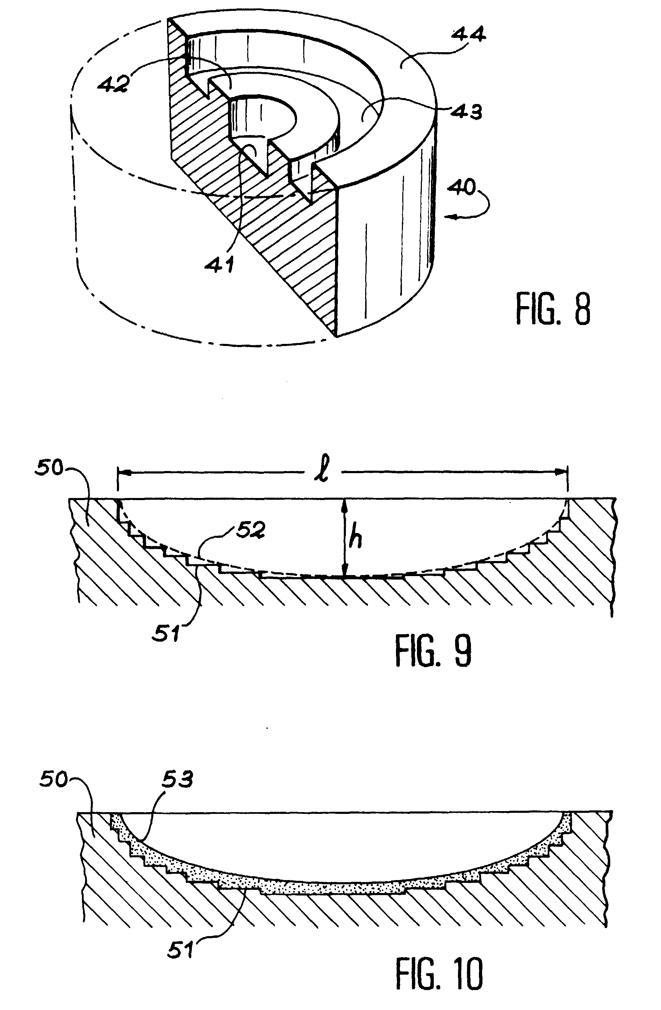

La figure 8 illustre un exemple d'application de l'invention. Il s'agit d'un prisme pour l'optique binaire. Le prisme 40 est de forme cylindrique. Sa face supérieure possède une structure en relief obtenue selon le procédé de l'invention. Le prisme 40 est par exemple constitué par la masse d'un substrat après enlèvement du film supérieur solidarisé au raidisseur. La structure est, dans le cas représenté, constituée d'un trou borgne central 41 et d'anneaux concentriques 42, 43 et 44 de hauteurs différentes.

Les figures 9 et 10 sont des vues en coupe qui illustrent une application de l'invention dans un domaine différent de l'optique binaire. Il s'agit d'obtenir un moule pour la réalisation d'un élément d'optique classique mais de taille réduite, par exemple une lentille en polymère.

On réalise, par le procédé de l'invention, une structure en relief 51 sur un support 50 en matériau semiconducteur, ce support étant constitué soit par un film adhérant à un raidisseur soit par le reste de la plaquette de semiconducteur utilisé. La structure 51 consiste en une approximation d'une cuvette 52 à obtenir. L'approximation est obtenue par une forme en escalier donnée à la structure.

La forme finale du moule est obtenue par utilisation d'un dépôt lissant 53 de silicium par exemple (voir la figure 10).

Une autre façon de faire consiste à réaliser la structure en relief en approchant le profil de la cuvette à obtenir mais sans l'atteindre, puis à polir finement la structure jusqu'à atteindre le profil voulu.

Par le procédé de l'invention, on peut obtenir par exemple une cuvette de 40 µm de diamètre pour 4 µm de profondeur maximale. L'invention est particulièrement intéressante pour obtenir des formes peu profondes, c'est-à-dire où le rapport h/l est faible. En effet, ces formes sont difficiles à réaliser par d'autres techniques.

L'élément optique à élaborer à partir d'un tel moule peut être alors obtenu par dépôt ou application sous pression d'une couche de polymère sur le moule.

## Revendications

1. Procédé de réalisation d'une structure en relief sur un support en matériau semiconducteur, consistant à soumettre une plaquette de ce matériau semiconducteur (1, 20) comportant une face plane (2, 21) dont le plan est soit sensiblement parallèle à un plan cristallographique principal dans le cas où le matériau semiconducteur est monocristallin, soit faiblement incliné par rapport à un plan cristallographique de mêmes indices pour tous les grains dans le cas où le matériau est polycristallin, aux trois étapes suivantes :
- une première étape d'implantation par bombardement de la face plane de ladite plaquette au moyen d'ions (3, 8, 22), créant des zones de microbulles gazeuses (4 à 7, 29), l'ensemble des zones définissant un profil dans le volume de ladite plaquette, chaque zone étant située par rapport à ladite face plane à une profondeur dépendant de l'énergie d'implantation des ions reçue par la surface de la face en regard de cette zone et étant de même géométrie que cette surface, ce profil délimitant, du côté de la face plane, une région supérieure (9, 30) de la plaquette constituant un film mince et, du côté opposé à la face plane, une région inférieure (10, 31) constituant la masse du substrat, les ions étant choisis parmi les ions de gaz rares ou de gaz hydrogène et la température de la plaquette pendant l'implantation étant maintenue au-dessous de la température à laquelle le gaz engendré par les ions implantés peut s'échapper du semiconducteur par diffusion ;
- une deuxième étape de solidarisation de la face plane (2, 21) de ladite plaquette avec un raidisseur (11, 32) constitué d'au moins une couche de matériau rigide ;
- une troisième étape de traitement thermique de l'ensemble constitué par la plaquette et le raidisseur à une température suffisante pour créer une séparation entre le film mince et la masse du substrat le long dudit profil, la séparation procurant une structure en relief sur le film mince et une structure en relief inversé sur le substrat.

2. Procédé selon la revendication 1, caractérisé en ce que, lors de la première étape, les zones (4 à 7) de microbulles gazeuses d'énergies d'implantation différentes sont obtenues par des étapes d'implantation successives.

3. Procédé selon la revendication 1, caractérisé en ce que, lors de la première étape, toutes les zones de microbulles gazeuses sont créées simultanément grâce à un écran (23) disposé sur le trajet des ions (22), l'écran étant apte à être traversé par les ions tout en atténuant leurs énergies et ayant une épaisseur variant localement selon un motif correspondant aux zones de microbulles à créer pour laisser passer l'énergie d'implantation nécessaire pour chaque zone.

4. Procédé selon l'une quelconque des revendications 1 à 3, caractérisé en ce que, en vue d'obtenir un profil de structure déterminé, on réalise d'abord une structure en relief approchant par excès ledit profil déterminé, puis on procède à une quatrième étape consistant à polir la structure approchante jusqu'à atteindre le profil déterminé.

5. Procédé selon l'une quelconque des revendications 1 à 3, caractérisé en ce que, en vue d'obtenir un profil de structure déterminé, on réalise d'abord une structure en relief (51) approchant par défaut ledit profil déterminé (52), puis on procède à une quatrième étape consistant à combler la structure approchante jusqu'à atteindre le profil déterminé.

6. Procédé selon l'une quelconque des revendications 1 à 5, caractérisé en ce que le semiconducteur est le silicium, les ions implantés sont des ions de gaz hydrogène ou d'hélium, la température d'implantation est comprise entre 20°C et 400°C et la température de la troisième étape de traitement thermique est supérieure à 450°C.

7. Procédé selon l'une quelconque des revendications 1 à 6, caractérisé en ce que le raidisseur (11, 32) est collé à ladite plaquette (1, 20) au moyen d'une substance adhésive.

8. Procédé selon l'une quelconque des revendications 1 à 6, caractérisé en ce que le raidisseur (11, 32) est solidaire de ladite plaquette (1, 20) par l'intermédiaire de liaisons inter-atomiques.

9. Application du procédé selon l'une quelconque des revendications 1 à 8 à la réalisation de dispositifs pour l'optique binaire.

10. Application du procédé selon l'une quelconque des revendications 1 à 8 à la réalisation de moules pour confectionner des dispositifs de taille réduite en polymère.

## Patentansprüche

1. Herstellungsverfahren für eine Reliefstruktur auf einem Substrat aus Halbleitermaterial, darin bestehend, ein Plättchen bzw. eine Scheibe dieses Halbleitermaterials (1, 20) mit einer planen Fläche (2, 21), deren Ebene entweder im wesentlichen parallel ist zu einer kristallosgraphischen Hauptfläche, falls das Halbleitermaterial monokristallin ist, oder schwach geneigt in Bezug auf eine kristallographische Fläche mit denselben Indizes für alle Körner, falls das Material polykristallin ist, den drei folgenden Schritten auszusetzen:
- einem ersten Schritt, in dem die plane Fläche des genannten Plättchens durch Ionenbeschuß (3, 8, 22) implantiert wird, um Zonen mit Mikrogasbläschen (4 bis 7, 29) zu bilden, wobei die Gesamtheit der Zonen in dem Volumen des genannten Plättchens ein Profil definiert, jede Zone sich in Bezug auf die genannte plane Fläche in einer Tiefe befindet, die abhängig ist von der Implantationsenergie der Ionen, aufgenommen durch die Oberfläche der dieser Fläche gegenüberstehenden Zone und mit derselben Geometrie wie diese Oberfläche, wobei dieses Profil auf der Seite der planen Fläche einen oberen Bereich (9, 30) des Plättchens begrenzt, der einen Dünnfilm bildet, und auf der entgegengesetzten Seite der planen Fläche einen die Masse des Substrats bildenden unteren Bereich (10, 31), die Ionen unter den Ionen von Edelgasen oder von Wasserstoffgas ausgewählt werden und die Temperatur des Plättchens während der Implantation unter der Temperatur gehalten wird, bei der das durch die implantierten Ionen erzeugte Gas durch Diffusion aus dem Halbleiter entweichen kann;
- einen zweiten Schritt, um die plane Fläche (2, 21) des genannten Plättchens mit einem Versteifer (11, 32) zu verbinden, gebildet durch wenigstens eine Schicht aus steifem Material;
- einen dritten Schritt, in dem die durch das Plättchen und den Versteifer gebildete Einheit mit einer ausreichenden Temperatur wärmebehandelt wird, um eine Trennung zwischen dem Dünnfilm und der Masse des Substrats längs des genannten Profils herzustellen, wobei die Trennung auf dem Dünnfilm zu einer Reliefstruktur führt und auf dem Substrat zu einer umgekehrten Reliefstruktur.

2. Verfahren nach Anspruch 1, dadurch gekennzeichnet, dass im ersten Schritt die Zonen (4 bis 7) der Mikrogasbläschen mit unterschiedlichen Implantationsenergien durch aufeinanderfolgende Implantationsschritte erzeugt werden.

3. Verfahren nach Anspruch 1, dadurch gekennzeichnet, dass im ersten Schritt alle Mikrogasbläschenzonen simultan dank eines Schirms (23) erzeugt werden, der auf dem Weg der Ionen (22) angeordnet wird, wobei dieser Schirm die Ionen durchläßt, dabei ihre Energien abschwächt und eine Dicke hat, die lokal nach einem Muster variiert, das den zu erzeugenden Mikrobläschenzonen entspricht, um für jede Zone die nötige Implantationsenergie durchzulassen.

4. Verfahren nach einem der Ansprüche 1 bis 3, dadurch gekennzeichnet, dass man, um ein Profil mit festgelegter Struktur herzustellen, eine Reliefstruktur realisiert, bei der man das genannte festgelegte Profil zunächst angenähert mit Übermaß herstellt und dann in einem vierten Schritt solange poliert, bis das festgelegte Profil erreicht ist.

5. Verfahren nach einem der Ansprüche 1 bis 3, dadurch gekennzeichnet, dass man hinsichtlich eines Profils mit festgelegter Struktur zunächst eine Reliefstruktur (51) mit Untermaß herstellt, die angenähert dem festgelegten Profil (52) entspricht, und dann in einem vierten Schritt die angenäherte Struktur ausfüllt, bis das festgelegte Profil erreicht ist.

6. Verfahren nach einem der Ansprüche 1 bis 5, dadurch gekennzeichnet, dass der Halbleiter Silicium ist, die implantierten Ionen Wasserstoff- oder Heliumgasionen sind, die Implantationstemperatur zwischen 20°C und 400°C enthalten ist, und die Temperatur des dritten Schritts, in dem die Wärmebehandlung erfolgt, höher als 450°C ist.

7. Verfahren nach einem der Ansprüche 1 bis 6, dadurch gekennzeichnet, dass der Versteifer (11, 32) mittels einer haftenden Substanz an dem Plättchen (1, 20) festgeklebt wird.

8. Verfahren nach einem der Ansprüche 1 bis 6, dadurch gekennzeichnet, dass der Versteifer (11, 32) mittels zwischenatomarer Bindungen fest mit dem genannten Plättchen verbunden ist.

9. Anwendung des Verfahrens nach einem der Ansprüche 1 bis 8 zur Herstellung von Vorrichtungen für die binäre Optik.

10. Anwendung des Verfahrens nach einem der Ansprüche 1 bis 8 zur Realisierung von Formen für die Herstellung von Vorrichtungen geringer Größe aus Polymer.

## Claims

1. Process for the production of a relief structure on a semiconductor material support, consisting of subjecting a wafer of said semiconductor material (1, 20) having a planar face (2, 21) and whose plane is either substantially parallel to a main crystallographic plane in the case where the semiconductor material is monocrystalline, or slightly inclined with respect to a crystallographic plane with the same indexes for all the grains in the case where the material is polycrystalline, to the three following stages:
- a first stage of implanting by bombardment of the planar face of said wafer by means of ions (3, 8, 22), creating areas of gas microbubbles (4 to 7, 29), all the areas defining a profile in the volume of said wafer, each area being positioned with respect to said planar face at a depth dependent on the implantation energy of the ions received by the surface of the face facing said area and being of the same geometry as said surface, said profile defining, on the side of the planar face, an upper region (9, 30) of the wafer constituting a thin film and, on the side opposite to the planar face, a lower region (10, 31) constituting the mass of the substrate, the ions being chosen from among hydrogen gas or rare gas ions and the temperature of the wafer during implantation being maintained below the temperature at which the gas produced by the implanted ions can escape from the semiconductor by diffusion,
- a second stage of joining the planar face (2, 21) of said wafer to a stiffener (11, 32) constituted by at least one rigid material layer,
- a third stage of heat treating the assembly constituted by the wafer and the stiffener at an adequate temperature for creating a separation between the thin film and the mass of the substrate along said profile, the separation bringing about a relief structure on the thin film and an inverted relief structure on the substrate.

2. Process according to claim 1, characterized in that, during the first stage, the areas (4 to 7) of gas microbubbles having different implantation energies are obtained by successive implantation stages.

3. Process according to claim 1, characterized in that, during the first stage, all the areas of gas microbubbles are simultaneously created by means of a screen (23) located on the path of the ions (22), the screen being traversable by the ions whilst reducing their energies and having a thickness varying locally in accordance with a pattern corresponding to the areas of microbubbles to be created in order to permit the passage of the necessary implantation energy for each area.

4. Process according to any one of the claims 1 to 3, characterized in that, with a view to obtaining a given structure profile, firstly a relief structure is produced approaching by excess said given profile and this is followed by a fourth stage consisting of polishing the approaching structure until the given profile is obtained.

5. Process according to any one of the claims 1 to 3, characterized in that, with a view to obtaining a given structure profile, firstly a relief structure (51) is produced, which approaches by default the same given profile (52) and this is followed by a fourth stage consisting of filling the approaching structure until the given profile is obtained.

6. Process according to any one of the claims 1 to 5, characterized in that the semiconductor is silicon, the implanted ions are helium or hydrogen gas ions, the implantation temperature is between 20 and 400°C and the temperature of the third heat treatment stage exceeds 450°C.

7. Process according to any one of the claims 1 to 6, characterized in that the stiffener (11, 32) is bonded to the wafer (1, 20) by means of an adhesive substance.

8. Process according to any one of the claims 1 to 6, characterized in that the stiffener (11, 32) is joined to said wafer (1, 20) by means of inter-atomic bonds.

9. Application of the process according to any one of the claims 1 to 8 to the production of devices for binary optics.

10. Application of the process according to any one of the claims 1 to 8 to the production of moulds for obtaining devices having a reduced size and made from polymer.
